# EUROPEAN PATENT SPECIFICATION

(11) **EP 1 137 953 B1**
(45) Date of publication and mention of the grant of the patent: **26.06.2002**
(21) Application number: 98966990.8
(22) Date of filing: 10.12.1998
(51) Int. Cl.: G01R 31/319, G11C 29/00

(54) **A TESTER INTERFACE SYSTEM FOR CURRENT DRIVE MODE MEMORY DEVICE**
EIN PRÜF-SCHNITTSTELLENSYSTEM ZUR ANSTEUERUNG VON BETRIEBSPEICHERVORRICHTUNGEN
SYSTEME D'INTERFACE DE TESTEUR POUR DISPOSITIF A MEMOIRE A MODE D'ATTAQUE DE COURANT

(43) Date of publication of application: 04.10.2001
(73) Proprietor: Acuid Limited, Dalkeith, Edinburgh EH22 2NA (GB)
(72) Inventor: STEPANOV, Vyacheslav Leonidovich, St.Petersburg, 194100 (RU); DEAS, Alexander, Roger, Dalkeith Edinburgh EH22 1JW (GB)
(86) International application number: RU9800414
(87) International publication number: WO0034797

(56) References cited:
- US-A- 4 523 143
- US-A- 5 842 155
- ANONYMOUS: "Precision Flat Pulse Driver" IBM TECHNICAL DISCLOSURE BULLETIN, vol. 27, no. 12, May 1985 (1985-05), pages 7210-7211, XP002117149 New York, US
- SCHOETRMER U ET AL: "HIGH PERFORMANCE PIN ELECTRONIC WITH GAAS, A CONTRADICTION IN TERMS" PROCEEDINGS OF THE INTERNATIONAL TEST CONFERENCE, BALTIMORE, SEPT. 20 - 24, 1992, no. CONF. 23, 20 September 1992 (1992-09-20), pages 538-545, XP000348786 INSTITUTE OF ELECTRICAL AND ELECTRONICS ENGINEERS ISBN: 0-7803-0760-7

## Description

### Technical Field

The present invention relates to the field. of automatic test equipment (ATE) for memory device testing, and more specifically, to an apparatus, e.g. tester, for testing and measuring the performance of semiconductor memories, this apparatus being especially suitable for testing high speed memory devices, such as current drive mode memory devices, for example Rambus devices.

The present invention is particularly applicable to a low cost test equipment interface system, capable of providing a high level of compatibility with current mode Rambus memories and permitting high speed testing procedures to be performed precisely at frequencies within the whole working range of Rambus devices.

### Background of the invention

Test systems used for testing memory devices should be able to test each new generation of memory devices at the maximum speed of the new device. When the latest generation of memory devices is manufactured, there should be a test system available which is capable of testing these new memory devices.

At present, a new generation of high speed memory devices employing current mode drivers is being developed. For example, Rambus includes a memory channel specification and associated DRAM technology that provide increased performance over prior memory system designs, offering up to 1.8 Gbytes per second of data transfer bandwidth. The Rambus memory channel specification includes a 9 or 18 bit data path, address and various control signals.

One characteristic feature of the Rambus specification which poses new problems for testing is that the signal level of Rambus memories differs from the conventional memory industry standard; the Rambus Signalling Level (RSL) operates at data rates of up to 800 MHz, while conventional signalling levels are typically less than 100Mz and usually between 20 and 60 MHz. Special tester interface systems are therefore now required, able operate with both RSL and conventional signalling levels. Another difficulty associated with the testing of this new generation of memory devices is that conventional semiconductor devices typically use voltage mode drivers, whereas memories such as Rambus use current mode drivers.

To test high speed memories such as Rambus, interface devices not only need to be compatible with high frequency signal levels, but also to provide current driving mode.

A high speed current mode bus and a bus receiver for interfacing integrated circuits have been described in US 5,355,391. The known system operates using small swing signals which enable efficient implementation of current mode drivers for low impedance signals. According to the known technical solution, it is preferable to use small swing logical levels, e.g. of V_{OH} (2.5 volts) and V_{OL} (2.0 volts) provided by CMOS integrated circuits.

A known invention that implements the above described CMOS technology is a Direct Rambus ASIC Cell (RAC) (Rambus ® ASIC Cell, Product Summary, Rambus Inc., California, USA) used in ASIC designs to interface the core logic of a CMOS ASIC device to a high-speed Rambus channel. The Direct RAC converts the high speed Rambus Signal Levels on the Rambus channel into the lower-speed CMOS-levels used by the ASIC designers. It performs packing and unpacking of high frequency data packets into wider and synchronous 128-bit data words. Though Rambus RAC is flexible enough to be used for various implementations, it is cost-ineffective in small scale production.

Attempts have been made to solve the problem of providing high speed data transfer in testing equipment to match the high speed performance offered by Rambus technology. For example, in US 5,463,643 a special technique is described, whereby data is split between several drives, permitting a data stream output which is several times faster than is possible when using a single drive, and which provides error correction for Rambus based memory systems. However, this solution requires a lot of extra equipment which may be disadvantageous in certain applications.

Another solution, described in US 5,794,175, is to access high speed memories at low frequencies of 100 MHz or less, thus avoiding the necessity of using high speed interface devices. However, this technique cannot provide adequate information about the performance of high speed memories, as these frequencies are below their working range.

Thus, recent developments in semiconductor technology, on one hand, and the limitations of conventional testing equipment, on the other hand, combine to create a requirement for a cost-efficient, high speed tester interface which is both compatible with current drive mode and able to provide reliable high speed data transmission at high frequencies, for example, within the Rambus Signalling level.

### Disclosure of the invention

It is an object of the present invention to provide a high speed interface between a tester and a high speed memory device under test (DUT), so that the tester can obtain real information about the working capabilities of the DUT when operating at high frequencies, for example the frequencies specified in the Rambus memory device specification.

It is also an object of the present invention to provide a current mode high speed driver for transferring data at high frequencies, for example the frequencies specified in the Rambus memory specification, to a device under test, for example a Rambus memory.

An advantage of the present invention is that the proposed tester interface can be made compact and lightweight so that it may be placed in a test head. A further advantage is that, according to the present invention whereby the tester interface system is positioned in the test head, the signal path to and/or from the DUT is reduced, thus avoiding excessive distortion of the timing signal, partially avoiding the necessity of calibrating the timing skew, and enhancing the accuracy of testing. A further advantage of the proposed invention is that compared with conventional universal test systems using expensive multi-purpose drivers and receivers, (e.g. US 5,794,175), the overall system is greatly simplified and the costs greatly reduced. By using, for example, standard ECL devices as components for the implementation of the tester receiver and driver, the cost of the tester interface may be minimised, while the speed and accuracy with which input and output data is transferred is maintained at the desired level. The important advantage of the proposed system is also that it allows high frequencies of up to 800 MHz and more to be used when testing Rambus memory devices. This is especially important because various characteristics of the operation of Rambus devices may only be revealed when the device is operating at its specified working frequencies, as signal frequency influences the accuracy of data transmission.

The substance of the present invention is a tester interface system for providing high speed signal transmission to and from a high speed synchronous memory device, the system comprising a driver for creating and transmitting input data to a memory device, and a receiver for receiving and comparing output data transmitted from said memory device, wherein the driver comprises a register, two level shifters, a current switcher and a current source, and the receiver comprises a differential input register.

The proposed tester interface is intended specially for testing high speed memory devices such as Rambus devices.

Gallium Arsenide or Emitter Coupled Logic (ECL) standard devices should preferably be used as components of the receiver means and driver means, as this allows the cost of the tester interface system to be greatly reduced.

Thus, in one aspect the invention is a hardware memory device tester interface system comprising a driving means for creating and transmitting input address, data and control signals to a DUT and a receiving means for receiving output signals from the DUT at a high RSL frequencies. In another aspect, the invention is a method of transmitting high speed test signals to a memory device under test.

For a better understanding of the present invention and to show how the same may be carried into effect, reference will now be made, by way of example, without loss of generality, to the accompanying drawings in which:

Fig.1 is an example circuit diagram of the tester interface comprising a driving means and a receiving means according to the first embodiment of the present invention.

Fig.2 is a detailed example circuit diagram of the driving means in accordance with the second embodiment of the present invention.

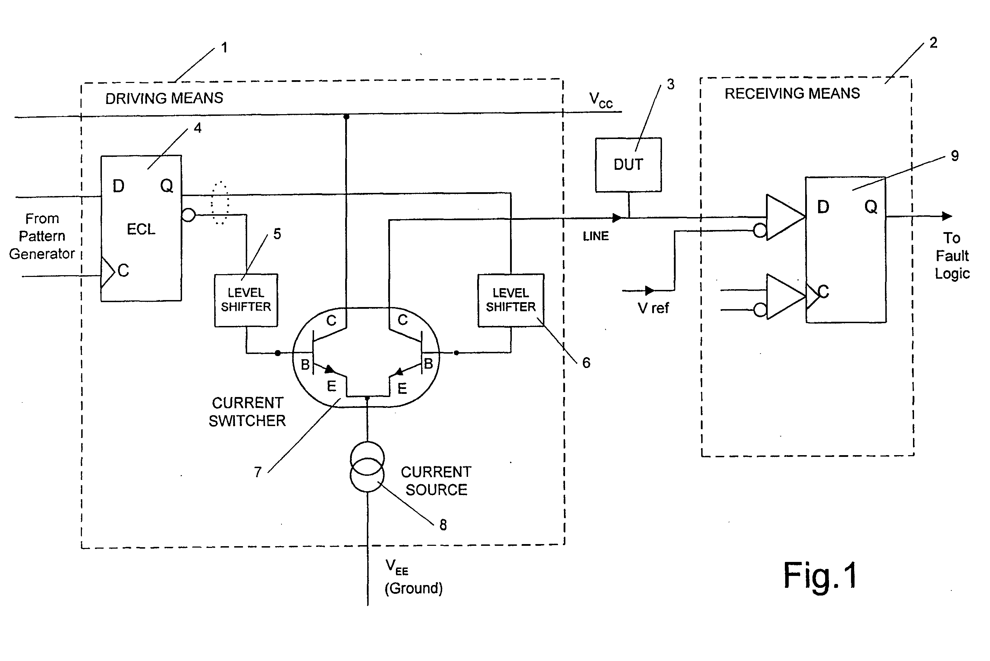

As shown in Fig.1, the tester interface system comprising a driving means 1 and a receiving means 2 is positioned in a tester head (not shown) and provides an interconnection between the tester and a device under test (DUT) 3. The test driving means 1 includes a register 4, two level shifters 5, 6, a current switcher 7 and a current source 8. The register 4 is intended for registering test signals received from the pattern generator and typically is a LVPECL (Low Voltage Positive Emitter Coupled Logic) register having a typical output voltages of V_{OH} = 2.35 V and V_{OL} = 1.30 V.

As the typical voltage levels of a high speed memory, such as a Rambus device, for example, Concurrent RDRAM, are lower than those of a LVPECL, the level shifters 5 and 6 are used for matching the voltage levels of the register and the DUT. Typically, the offset value of level shifters 5 and 6 is about 0.8 V, to reduce the voltage to V_{OH} = 1.55 V and V_{OL} = 0.50 V which is appropriate for driving the current switcher 7.

Preferably, an open diode or a transistor base-emitter junction should be used as the voltage shifter.

The current switcher 7 is preferably implemented on the basis of an integral transistor pair. The current switcher 7 manipulates the current supplied by the current source 8 under the control of signals provided by the register 4. The current is either applied to the high speed memory (for example, via a Rambus channel line), or shortened to a V_{cc} (sometimes designated as V_{dd}) power line.

The current source 8 provides the current value required by the RSL specification. A so-called "current mirror" may be used as the current source 8 (see also Paul Horowitz, Winfield Hill, "The Art of Electronics", Cambridge University Press, Second Edition, 1989).

The driving circuit shown in Fig.1 operates as follows. The register 4 receives a special pattern of signals from the pattern generator and creates opposite phase test signals. Preferably ECL devices are used as registers as these permit high frequencies up to 1 GHz and higher to be employed. Thanks to the superior timing parameters typical of ECL devices, particularly very low skew, both within device and from device to device, a step of skew calibration may be totally avoided or at least simplified. With the use of ECL devices, a total system skew of less than ±100 ps can be achieved without the use of a delay tuning means. For some tester applications such a low skew may be tolerable for interfacing Rambus devices. Thus, employing a tester interface as suggested in the proposed invention at least permits the deskewing means to be greatly simplified, and may allow it to be omitted altogether.

To make the test signals compatible with high frequency signalling levels (such as Rambus Signalling Level), the following two operations are carried out: 1) voltage level shifting, and 2) generating current to be applied to a high frequency signalling level line (e.g. a Rambus Channel line in accordance with the RSL specification).

Thus, the voltage supplied by the register 4 is subsequently adjusted by level shifters 5 and 6, and the outputs of register 4 are therefore connected to the inputs of the level shifters 5 and 6. The outputs of the level shifters 5 and 6 are connected to the bases of transistors constituting the current switcher 7. The jointed emitters of these transistors are connected further to the current source 8. One of their collectors is connected to a power supply voltage line V_{cc}, while the other collector is connected to a line leading to the DUT under test, which may be a Rambus Channel.

As also shown in Fig.1, output signals from the DUT are received by a receiving means 2 which comprises a differential input register 9. According to the present invention, the output signals are transmitted to one of the data inputs of the differential input register (DIR) 9, while the reference voltage V_{ref} is applied to another data input, whereupon the input circuitry of the DIR functions as a comparator, directing the DUT output signals to either low or high logic level. Clock signals are transmitted to the clock input of the DIR register 9. The result of the comparison may be transmitted to a suitable fault logic analyser, or ATE system, or any other appropriate measurement apparatus corresponding to the requirements of the measurement system used.

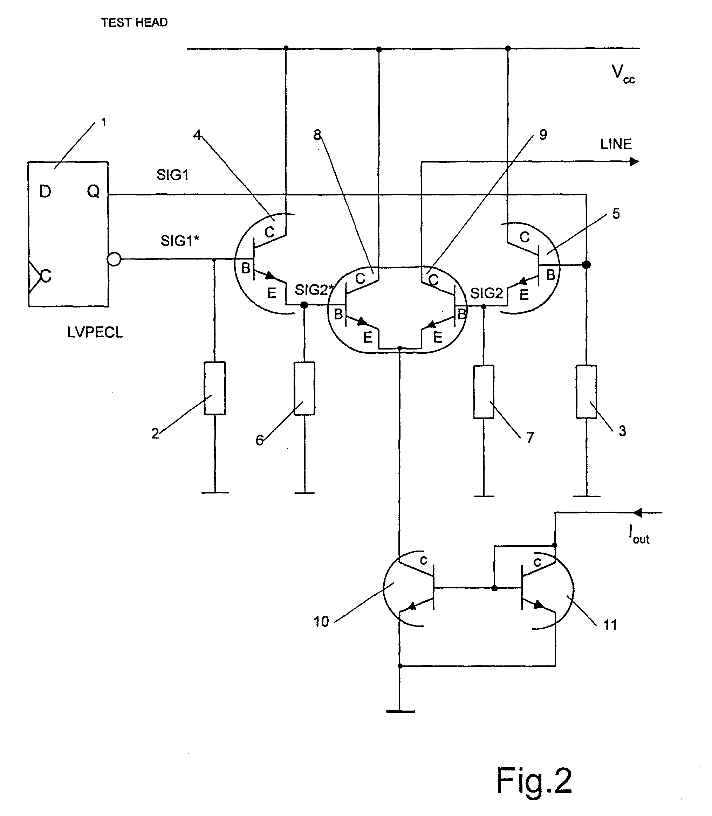

According to the second example embodiment of the present invention, the proposed test interface system includes the driving means shown in Fig.2. The driving means of Fig.2 operates as follows.

A register 1 which may be, for example, a LVPECL device, generates at its outputs complementary signals SIG1 and SIG1*. The logic levels of the said signals SIG1 and SIG1* correspond to the LVPECL technology specification, i.e. their typical values are V_{OH} = 2.35 V and V_{OL} = 1.30 V. Resistors 2 and 3 provide mandatory current sink paths for the said LVPECL signals.

To bring the signals into compliance with the desired RSL signal levels, high speed n-p-n junction transistors 4 and 5 are used for performing level shifting between the base terminals and the emitter terminals. Resistors 6 and 7 provide the current sink path for the emitter currents of the said transistors 4 and 5. On the emitter terminals of transistors 4 and 5, voltage values of V_{H} = 1.55 V and V_{L} = 0.50 V respectively are obtained for the logic low and high levels.

The resulting signals SIG2 and SIG2* are transmitted further to the base terminals of the transistor pair formed by transistors 8 and 9. Depending on the voltage levels of the signals SIG2 or SIG2*, which always change in opposite phases by virtue of their differential nature, one of the transistors 8 or 9 is open, while the other is closed. For example, when SIG2 is a high level signal (V_{H} = 1.55 V) and SIG2* is a low level signal (V_{L} = 0.50 V), transistor 9 is open and transistor 8 is closed. In this case, current generated by the current source 10,11 flows across the emitter and collector of transistor 9. Alternatively, when transistor 8 is open and transistor 9 is closed, current generated by the current source 10,11 flows across the emitter and collector of transistor 8. The collector of transistor 8 is connected directly to V_{cc}, while the collector of transistor 9 is switched to the Rambus line.

The joint emitter of the transistors 8 and 9 is connected to a current source formed by transistors 10,11 which is described below.

Thus, transistors 8 and 9 switch the current generated by the current source 10,11 either to the power supply voltage V_{cc}, or to the line conducting to the high frequency channel, for example Rambus Channel. A current mode driver is thereby provided in relation to the channel; either the current flows from the Rambus Channel across the collector of transistor 9, or no current is supplied into Rambus Channel, thus complying with the Rambus Channel specification.

The transistors 10 and 11 form the so-called "current mirror" (which is described in detail in Horwitz and Hill "The Art of Electronics"), i.e. they are connected in such a way that the current flowing into the collector of transistor 10 is equal to the current flowing into the collector of transistor 11. Thus, by varying the current value input into the collector of transistor 11, the current value input into the collector of transistor 10 may be also varied, i.e. the current applied to the Rambus Channel may be varied.

Various implementations of the proposed test interface system can be made.

For example, level shifters may be implemented in diodes substituting for transistors 4 and 5 with their corresponding resistors 2 and 3 as shown in Fig.2.

Another modification is possible when the LVPECL registers are replaced by ECL registers with negative output voltage levels. If this is done, the output signals of the register may be transmitted directly to current switcher transistors.

It will be appreciated that the Figures described above are example embodiments only and that various modifications and changes can be made in the electrical circuit and arrangement of the parts or elements of the embodiments described herein without departing from the scope of the invention.

## Claims

1. A tester interface system for providing high speed signal transfer to and from a high speed memory device (3), the system comprising a driving means (1) for creating and transmitting input data to the memory device and a receiving means (2) for receiving and comparing output data transmitted from said memory device (3), wherein
- the driving means (1) contains a register (4), two level shifters (5,6), a current switcher (7) and a current source (8), and
- the receiving means (2) comprises a differential input register (9).

2. A tester interface system according to claim 1, wherein
- the current switcher (7) comprises an integral transistor pair,
- the inputs of the register (4) of the driving means (1) serve to receive signals from the pattern generator, the outputs of the register (4) are connected to the inputs of the level shifters (5, 6), the outputs of the level shifters are connected to the bases of the integral transistor pair, the joint emitter of the integral transistor pair is connected to the current source (8), one of the collectors of the integral transistor pair is connected to a power supply voltage, while the other collector is connected to the line leading to the high speed memory device (3).

3. A tester interface according to claim 1 or 2, wherein the differential input register (4) comprises an ECL differential input register.

4. A tester interface according to any one of claims 1 to 3, wherein one of inputs of the differential input register (4) is connected to the channel for receiving test signals from the high speed memory device under test (3), while the other input of the register (4) receives reference signals.

5. A tester interface according to any one of claims 1 to 4, wherein the differential input register (4) comprises a LVPECL differential input register.

6. A tester interface according to any one of claims 1 to 5, wherein the high speed memory device (3) is selected from a group including Rambus device, Concurrent Rambus device and Direct Rambus device.

7. A tester interface according to any one of claims 1 to 6, wherein the current source (8) comprises a current mirror.

8. A tester interface according to any one of claims 1-4, wherein the driving means converts differential voltage signals into differential current signals.

9. A tester interface system for providing high speed signal transfer to and from a high speed memory device (3), the system comprising a driving means (1) for creating and transmitting input data to the high speed memory device and a receiving means (2) for receiving and comparing output data transmitted from said memory device (3), wherein
- the driving means (1) comprises an ECL differential input register (4), a current switcher (7) and a current source (8), and
- the receiving means (2) comprises a differential input register (9).

10. A tester interface system according to claim 9, **characterised in that** the current switcher (7) comprises an integral transistor pair, the inputs of the register (4) of the driving means (1) serve for receiving signals from the pattern generator, the outputs of the register (4) are connected to the bases of the integral transistor pair, the joint emitter of the integral transistor pair is connected to the current source (8), one of the collectors of the integral transistor pair is connected to a power supply voltage, while the other collector is connected to the line leading to the memory device (3).

## Patentansprüche

1. Prüfgerätschnittstellenanordnung zum Bereitstellen einer Hochgeschwindigkeitssignalübertragung zu und von einem Hochgeschwindigkeitsspeicherbauelement (3), wobei die Anordnung eine Treibereinrichtung (1) zum Erzeugen und Übertragen von Eingangsdaten an das Speicherbauelement und eine Empfangseinrichtung (2) zum Empfangen und Vergleichen von Ausgangsdaten, welche von dem Speicherbauelement (3) übertragen werden, aufweist, wobei
- die Treibereinrichtung (1) ein Register (4), zwei Pegelschieber (5,6), einen Stromschalter (7) und eine Stromquelle (8) enthält, und
- die Empfangseinrichtung (2) ein differentielles Eingangsregister (9) aufweist.

2. Prüfgerätschnittstellenanordnung gemäß Anspruch 1, wobei
- der Stromschalter (7) ein integrales Transistorpaar aufweist,
- die Eingänge des Registers (4) der Treibereinrichtung (1) dazu dienen, Signale von dem Mustergenerator zu empfangen, die Ausgänge des Registers (4) mit den Eingängen der Pegelschieber (5,6) verbunden sind, die Ausgänge der Pegelschieber mit den Basen des integralen Transistorpaares verbunden sind, der verbundene Emitter des integralen Transistorpaares mit der Stromquelle (8) verbunden ist, einer der Kollektoren des integralen Transistorpaares an eine Energieversorgungsspannung angeschlossen ist, während der andere Kollektor mit der Leitung verbunden ist, welche zu dem Hochgeschwindigkeitsspeicherbauelement (3) führt.

3. Prüfgerätschnittstelle gemäß Anspruch 1 oder 2, wobei das differentielle Eingangsregister (4) ein differentielles ECL-Eingangsregister aufweist.

4. Prüfgerätschnittstelle gemäß einem der Ansprüche 1 bis 3, wobei einer der Eingänge des differentiellen Eingangsregisters (4) mit dem Kanal zum Empfangen von Prüfsignalen von dem in Prüfung befindlichen Hochgeschwindigkeitsspeicherbauelement (3) verbunden ist, während der andere Eingang des Registers (4) Referenzsignale empfängt.

5. Prüfgerätschnittstelle gemäß einem der Ansprüche 1 bis 4, wobei das differentielle Eingangsregister (4) ein differentielles LVPECL-Eingangsregister aufweist.

6. Prüfgerätschnittstelle gemäß einem der Ansprüche 1 bis 5, wobei das Hochgeschwindigkeitsspeicherbauelement (3) aus einer Gruppe, welche Rambus-Bauelement, Concurrent-Rambus-Bauelement und Direct-Rambus-Bauelement einschließt, ausgewählt ist.

7. Prüfgerätschnittstelle gemäß einem der Ansprüche 1 bis 6, wobei die Stromquelle (8) einen Stromspiegel aufweist.

8. Prüfgerätschnittstelle gemäß einem der Ansprüche 1-4, wobei die Treibereinrichtung differentielle Spannungssignale in differentielle Stromsignale umwandelt.

9. Prüfgerätschnittstellenanordnung zum Bereitstellen einer Hochgeschwindigkeitssignalübertragung zu und von einem Hochgeschwindigkeitsspeicherbauelement (3), wobei die Anordnung eine Speichereinrichtung (1) zum Erzeugen und Übertragen von Eingangsdaten an das Hochgeschwindigkeitsspeicherbauelement und eine Empfangseinrichtung (2) zum Empfangen und Vergleichen von Ausgangsdaten, welche von dem Speicherbauelement (3) übertragen werden, aufweist, wobei
- die Treibereinrichtung (1) ein differentielles ECL-Eingangsregister (4), einen Stromschalter (7) und eine Stromquelle (8) aufweist, und
- die Empfangseinrichtung (2) ein differentielles Eingangsregister (9) aufweist.

10. Prüfgerätschnittstellenanordnung gemäß Anspruch 9, **dadurch gekennzeichnet, daß** der Stromschalter (7) ein integrales Transistorpaar aufweist, die Eingänge des Registers (4) der Treibereinrichtung (1) zum Empfangen von Signalen von dem Mustergenerator dienen, die Ausgänge des Registers (4) mit den Basen des integralen Transistorpaars verbunden sind, der verbundene Emitter des integralen Transistorpaars mit der Stromquelle (8) verbunden ist, einer der Kollektoren des integralen Transistorpaars an eine Energieversorgungsspannung angeschlossen ist, während der andere Kollektor mit der Leitung, welche zu dem Speicherbauelement (3) führt, verbunden ist.

## Revendications

1. Système d'interface de testeur pour fournir un transfert de signaux à vitesse élevée vers et en provenance d'un dispositif de mémoire à vitesse élevée (3), le système comprenant des moyens de commande (1) pour créer et transmettre des données d'entrée au dispositif de mémoire et des moyens de réception (2) pour recevoir et comparer des données de sortie transmises par ledit dispositif de mémoire (3), dans lequel
- les moyens de commande (1) contiennent un registre (4), deux dispositifs de décalage de niveaux (5,6), un commutateur de courant (7) et une source de courant (8), et
- les moyens de réception (2) comprennent un registre d'entrées différentielles (9).

2. Système d'interface de testeur selon la revendication 1, dans lequel
- le commutateur de courant (7) comprend une paire de transistors monobloc,
- les entrées du registre (4) des moyens de commande (1) servent à recevoir les signaux du générateur de dessin , les sorties du registre (4) sont connectées aux entrées des dispositifs de décalage de niveaux (5,6), les sorties des dispositifs de décalage de signaux sont connectées aux bases de la paire de transistors monobloc, l'émetteur commun de la paire de transistors monobloc est connecté à la source de courant (8), l'un des collecteurs de la paire de transistors monobloc est connecté à une tension d'alimentation électrique, tandis que l'autre collecteur est connecté à la ligne menant au dispositif de mémoire à vitesse élevée (3).

3. Interface de testeur selon la revendication 1 ou 2, dans lequel le registre d'entrées différentielles (4) comprend un registre d'entrées différentielles ECL (circuit de logique couplé à l'émetteur).

4. Interface de testeur selon l'une quelconque des revendications 1 à 3, dans lequel l'une des entrées du registre d'entrées différentielles (4) est connecté au canal pour recevoir les signaux de test en provenance du dispositif de mémoire à vitesse élevée (3) soumis au test, tandis que l'autre entrée du registre (4) reçoit les signaux de référence.

5. Interface de testeur selon l'une quelconque des revendications 1 à 4, dans lequel le registre d'entrées différentielles (4) comprend un registre d'entrées différentielles LVPECL.

6. Interface de testeur selon l'une quelconque des revendications 1 à 5, dans lequel le dispositif de mémoire à vitesse élevée (3) est choisi dans le groupe comprenant un dispositif Rambus, un dispositif Concurrent Rambus (en simultanéité) et un dispositif Direct Rambus (direct).

7. Interface de testeur selon l'une quelconque des revendications 1 à 6, dans lequel la source de courant (8) comprend un miroir de courant.

8. Interface de testeur selon l'une quelconque des revendications 1-4, dans lequel les moyens de commande convertissent des signaux de tension différentielle en signaux de courant différentiel.

9. Système interface de testeur pour assurer un transfert de signaux à vitesse élevée vers et en provenance d'un dispositif de mémoire à vitesse élevée (3), le système comprenant des moyens de commande (1) pour créer et transmettre des données d'entrée au dispositif de mémoire à vitesse élevée et des moyens de réception (2) pour recevoir et comparer des données de sortie transmises par ledit dispositif de mémoire (3), dans lequel
- les moyens de commande (1) comprennent un registre d'entrées différentielles ECL (4), un commutateur de courant (7) et une source de courant (8), et
- les moyens de réception (2) comprennent un registre d'entrées différentielles (9).

10. Système interface de testeur selon la revendication 9, **caractérisé en ce que** le commutateur de courant (7) comprend une paire de transistors monobloc, les entrées du registre (4) des moyens de commande (1) servent à recevoir les signaux en provenance du générateur de dessin, les sorties du registre (4) sont connectées aux bases de la paire de transistors monobloc, l'émetteur commun de la paire de transistors monobloc est connecté à la source de courant (8), l'un des collecteurs de la paire de transistors monobloc est connecté à une tension d'alimentation électrique, tandis que l'autre collecteur est connecté à la ligne menant au dispositif de mémoire (3).
